# EUROPEAN PATENT APPLICATION

(11) **EP 2 629 073 A1**
(43) Date of publication of application: **21.08.2013**
(21) Application number: 10858347.7
(22) Date of filing: 15.10.2010
(51) Int. Cl.: G01K 1/14, H05K 7/20

(54) **DEVICE FOR DETECTING TEMPERATURE OF COOLING LIQUID**

(71) Applicant: Toyota Jidosha Kabushiki Kaisha, Toyota-shi, Aichi 471-8571 (JP)
(72) Inventor: TOMITA, Yoshiki, Toyota-shi, Aichi 471-8571 (JP); OHTSUKA, Kenji, Toyota-shi, Aichi 471-8571 (JP); HIRATA, Shuichi, Toyota-shi, Aichi 471-8571 (JP)
(74) Representative: TBK
(86) International application number: PCT/JP2010/068131
(87) International publication number: WO 2012/049765

(57) **Abstract**

A device (10) for detecting a temperature of a cooling liquid has: a cooling section (16) having a cooling liquid flowing therein; a temperature sensor (18), which detects a temperature of the cooling liquid; and a bracket (20), which supports the temperature sensor (18), is solder-bonded to the cooling section (16), and transfers heat of the cooling liquid to the temperature sensor (18). The bracket (20) has formed therein a slit (32) that communicates between the outside and the bonding surface (30) bonded to the cooling section (16). With this configuration, deterioration of heat conductivity due to the solder bonding can be suppressed.

## Description

### TECHNICAL FIELD

The present invention relates to an improved structure of a temperature detecting device for cooling liquid that detects the temperature of a cooling liquid.

### BACKGROUND ART

Technology for mounting a cooling section in which a cooling liquid flows to electrical equipment in order to cool a heating element of the electric equipment has been conventionally known. With this technology, the temperature of the heating element, which is a subject of cooling, is estimated based on a detection result from a temperature sensor that detects the temperature of the cooling liquid, thereby performing temperature control of the electrical equipment, for example.

The following Patent Literature 1 describes a water cooling heat sink for cooling electrical equipment. The heat sink and an entrance/exit pipe through which cooling water flows into and from the heat sink are bonded together by brazing.

### PRIOR ART DOCUMENTS

### PATENT LITERATURE

Patent Literature 1: JP 2008-211147 A

### SUMMARY OF THE INVENTION

### TECHNICAL PROBLEMS

In the above water cooling heat sink as described in Patent Literature 1, as in the conventional art, there is a case in which a temperature sensor for detecting the temperature of the cooling water is provided on the heat sink or the entrance/exit pipe in view of temperature control of the electrical equipment. In this case, in consideration of the manufacturing efficiency, a bracket that supports the temperature sensor, and the heat sink or the entrance/exit pipe, are fixed together by the above-described bonding method, i.e. by brazing.

Heat conductivity is required for the bracket for transferring the heat of the cooling water to the temperature sensor with high efficiency. In order to increase the heat conductivity, it can be considered to enlarge a bonding surface of the bracket that is bonded to the heat sink or the entrance/exit pipe. However, simple enlargement of the bonding surface would result in formation of voids during brazing, leading to a problem that heat conduction is inhibited.

Further, strength which is necessary for supporting the temperature sensor is also required for the bracket. In order to secure the strength, it is necessary to ensure a predetermined volume for the bracket. This would, however, cause a problem that it takes time for the heat to transfer to the temperature sensor due to the influence of the heat capacity of the bracket corresponding to the predetermined volume.

It is therefore an advantage of the present invention to provide a device for detecting a temperature of a cooling liquid that is capable of suppressing a reduction in the thermal conductivity caused by braze-bonding of elements, with a simple structure.

### SOLUTION TO PROBLEMS

In accordance with an aspect of the invention, there is provided a device for detecting a temperature of a cooling liquid, including a cooling section in which a cooling liquid flows, a temperature sensor that detects a temperature of the cooling liquid, and a bracket that supports the temperature sensor and is braze-bonded to the cooling section, the bracket transferring heat of the cooling liquid to the temperature sensor, wherein a communication portion that communicates between a bonding surface that is bonded to the cooling section and the outside is formed in the bracket.

Further, it is preferable that the bracket includes one end portion which is a region that is bonded to the cooling section, and the other end portion which is a region where the temperature sensor is provided, with a thickness of the one end portion being smaller than a thickness of the other end portion.

Also, it is preferable that the communication portion is slits that are formed on the bonding surface of the bracket.

Moreover, it is preferable that the slits are formed at intervals of 3 mm or less.

Additionally, it is preferable that the communication portion is a through hole that is formed to pass through the bonding surface of the bracket and a surface that is opposite to the bonding surface.

Furthermore, it is preferable that the cooling section is mounted on electrical equipment for cooling a heating element of the electrical equipment.

### ADVANTAGEOUS EFFECTS OF INVENTION

According to the temperature detecting device for cooling liquid of the present invention, it is possible to suppress a reduction in the heat conductivity caused by braze-bonding of elements, with a simple structure. Further, according to this device, it is possible to enhance responsiveness of the temperature sensor with a simple structure.

### BRIEF DESCRIPTION OF THE DRAWINGS

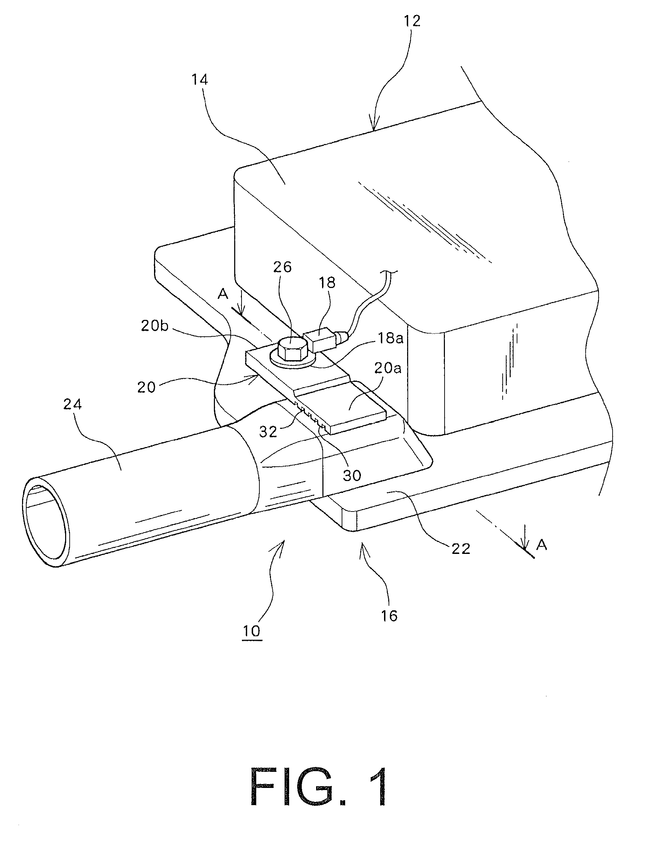

[FIGURE 1]
   View illustrating a structure of a temperature detecting device for cooling liquid according to the present embodiment.
[FIGURE 2]
   Cross sectional view taken along line A-A in FIG. 1.
[FIGURE 3]
   View illustrating a structure of a bracket.

### MODE FOR CARRYING OUT THE INVENTION

A preferred embodiment of a temperature detecting device for cooling liquid according to the present invention will be described with reference to the drawings. Here, a temperature detecting device for cooling liquid that detects the temperature of a cooling liquid that cools a semiconductor module provided in a power module that supplies electric power to a motor for driving a motor vehicle will be described, for example. However, the present invention is also applicable to a temperature detecting device for cooling liquid that detects the temperature of a cooling liquid that cools a heating element of electrical equipment, not limited to the power module of a motor vehicle.

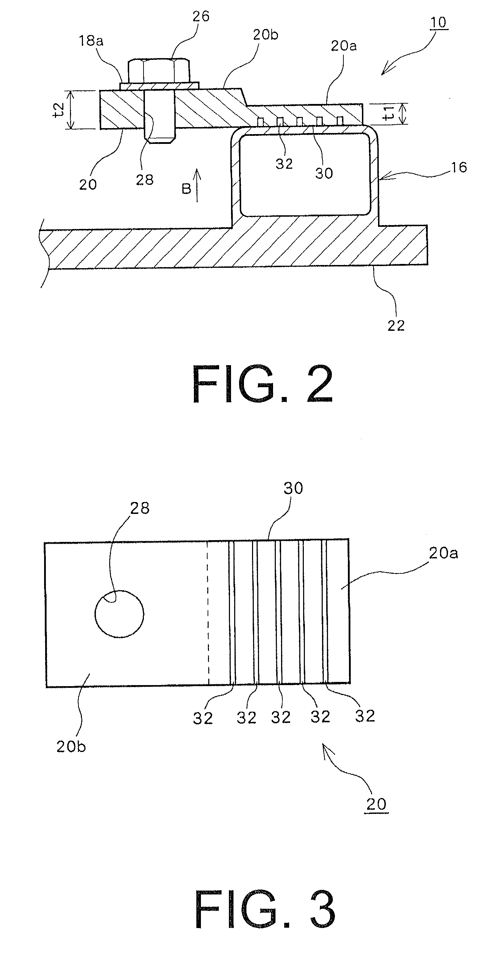

FIG. 1 is a view illustrating a structure of a temperature detecting device for cooling liquid according to the present embodiment and FIG. 2 is a cross sectional view taken along line A-A in FIG. 1.

A temperature detecting device for cooling liquid (which will hereinafter be simply referred to as a "temperature detecting device") 10 is attached to a power module 12. The power module 12 includes a housing 14 for storing a semiconductor module (not shown) that is a heating element and a control section (not shown) that controls this module. The housing 14 is formed of a material having a high insulating property, such as a resin (including a bicomponent fiber material).

The semiconductor module includes a semiconductor element and a substrate on which this element is disposed, although not shown. The semiconductor element is a switching element that is used for an inverter and a booster converter, and is composed of IGBT, a power transistor, a thyristor, and so on. The switching element generates heat when it is driven. The substrate includes an electric circuit, on which the semiconductor element is electrically connected.

In the semiconductor module configured as described above, in view of preventing damage to the semiconductor element, an operating temperature range (particularly the upper limit temperature) is preset. The control section of the power module 12 controls to restrict the performance of the semiconductor module, before the operating temperature range is exceeded.

The temperature detecting device 10 includes a cooling section 16 in which a cooling liquid flows, and a temperature sensor 18 that detects the temperature of the cooling liquid. The temperature detecting device 10 also includes a bracket 20 that supports the temperature sensor 18 and that is braze-bonded to the cooling section 16. The cooling liquid according to the present embodiment is a cooling medium that is used for a motor vehicle, such as ATF (Automatic Transmission Fluid) or LLC (Long Life Coolant), for example.

The cooling section 16 includes a cooling unit 22 connected to the power module 12 and a flow passage 24 connected to each of an entrance port and an exit port of the cooling unit 22. The cooling unit 22 and the flow passage 24 are both formed of a material having excellent heat conductivity such as aluminum, and are braze-bonded to each other.

The cooling unit 22 of the present embodiment is connected to the lower portion of the housing 14 of the power module 12, as illustrated in FIG. 1. The cooling unit 22 dissipates the heat of the semiconductor module within the housing 14 to the cooling liquid. As the cooling unit 22 is formed of aluminum, as described above, it is possible to dissipate the heat of the semiconductor module to the cooling liquid with high efficiency. The flow passage 24 of the present embodiment is connected to a pump and a heat dissipation member (both of which are not shown) for dissipating the heat of the semiconductor module to the outside.

The structure of the bracket 20 will now be described with reference to FIGs. 1 to 3. FIG. 3 is a view illustrating the structure of the bracket 20 and is a plan view seen from the B direction in FIG. 2.

The bracket 20 is formed of a material having excellent heat conductivity, such as aluminum. As the bracket 20 is thus formed of aluminum, it is possible to transfer the heat of the cooling liquid flowing in the cooling section 16 to the temperature sensor 18 with high efficiency. The bracket 20 includes one end portion 20a which is a region to be bonded to the cooling section 16 and the other end portion 20b which is a region on which the temperature sensor 18 is provided. While the bracket 20 of the present embodiment is bonded to the entrance port i.e. the upstream side, of the cooling section 16, the present invention is not limited to this structure and the bracket 20 may be bonded to the exit port i.e. the downstream side, of the cooling section 16.

The other end portion 20b includes a threaded hole 28 formed therein, into which a bolt 26 is to be screw fitted. The temperature sensor 18 includes a terminal 18a through which the bolt 26 passes. By screwing the bolt 26 passing through this terminal 18a into the threaded hole 28, the temperature sensor 18 is fixed to the other end portion 20b. The temperature sensor 18 of the present embodiment is a thermistor, and a detection value of the temperature sensor 18 is output to the control section of the power module 12. This method of fixing the temperature sensor 18 to the bracket 20 is only one example, and the present invention is not limited to this structure and other fixing methods, including welding, for example, may be adopted.

On the other hand, the one end portion 20a includes a bonding surface 30 that is bonded to the cooling section 16. While the bonding surface 30 of the present embodiment is bonded to the cooling unit 22, this structure is only one example and the bonding surface 30 can be bonded to the flow passage 24. On the bonding surface 30, five slits 32 are formed at predetermined intervals. Here, the number of slits 32 indicated above is only one example and is not limited to five.

By forming the slits 32 on the bonding surface 30 as described above, it is possible to transfer the air generated on the bonding surface 30 during brazing to the outside through these slits. As formation of voids can be prevented by the transfer of the air, it is possible to prevent a reduction in the thermal conductivity from the cooling section 16 to the bracket 20 caused by such voids.

It is preferable that the slits 32 are formed at intervals of 3 mm or less, for example. With this structure, it is possible to transfer the air generated on the bonding surface 30 through the slits 32 with high efficiency. Here, this interval can also be applied to both ends on the bonding surface 30. More specifically, this interval of 3 mm or less can be applied to the interval between the right end slit 32 and the right end of the one end portion 20a and to the interval between the left end slit 32 and the left end (indicated by a broken line) of the one end portion 20a illustrated in FIG. 3.

Further, the bracket 20 of the present embodiment is characterized in that the thickness t1 of the one end portion 20a is smaller than the thickness t2 of the other end portion 20b. Here, the thicknesses t1 and t2 refer to the length of the bracket 20 in the direction which is orthogonal to the bonding surface 30.

With this structure, it is possible to secure the strength which is necessary for supporting the temperature sensor 18 with the other end portion 20b, while reducing the volume, that is the heat capacity, of the bracket 20 in the one end portion 20a. By reducing the heat capacity of the bracket 20, the time required for the transfer of the heat from the cooling section 16 to the temperature sensor 18 can be shortened, so that responsiveness of the temperature sensor 18 can be increased.

With the temperature detecting device 10 of the present embodiment, due to the characteristics structure of the bracket 20 as described above, it is possible to detect the temperature of the cooling liquid with high accuracy. Consequently, as the accuracy of detection of the temperature of the semiconductor module via the cooling liquid is increased, it is possible to set the preset upper limit temperature of the semiconductor module, which is set in consideration of an error or a margin, to a higher temperature. As, with the increase in the upper limit temperature, it becomes less necessary to restrict the performance of the semiconductor module, an increase in the driving performance of the motor vehicle can be achieved. Further, as the upper limit value for surge voltage protection can also be set higher with the increase in the upper limit temperature, the operation of the semiconductor element can be enhanced due to the surplus voltage obtained accordingly, which would result in an increase in the fuel efficiency performance.

While in the present embodiment an example in which the cooling section 16 and the bracket 20 are formed of aluminum has been described, the present invention is not limited to this structure, and they may be formed of any material with excellent heat conductivity, such as copper.

Further, while in the above embodiment an example in which the slits 32 are formed on the bonding surface 30 of the bracket 20 has been described, the present invention is not limited to this structure. Any other structures may be adopted as long as they are configured to communicate between the bonding surface 30 and the outside and to allow the air generated on the bonding surface 30 to transfer to the outside to thereby avoid formation of voids during brazing. For example, a through hole formed through the bonding surface 30 and the surface of the one end portion 20a opposite to the bonding surface 30 may be provided, in place of the slits 32.

### REFERENCE SYMBOLS LIST

10 temperature detecting device for cooling liquid, 12 power module, 14 housing, 16 cooling section, 18 temperature sensor, 20 bracket, 22 cooling unit, 24 flow passage, 26 bolt, 28 threaded hole, 30 bonding surface, 32 slit.

## Claims

1. A device for detecting a temperature of a cooling liquid, the device comprising:
a cooling section in which a cooling liquid flows;
a temperature sensor that detects a temperature of the cooling liquid; and
a bracket that supports the temperature sensor and is braze-bonded to the cooling section, the bracket transferring heat of the cooling liquid to the temperature sensor,
wherein a communication portion for communicating between a bonding surface of the bracket that is bonded to the cooling section and the outside is formed in the bracket.

2. The device for detecting a temperature of a cooling liquid according to Claim 1, wherein
the bracket includes one end portion, which is a region that is bonded to the cooling section, and another end portion which is a region on which the temperature sensor is provided, and
a thickness of the one end portion is smaller than a thickness of the other end portion.

3. The device for detecting a temperature of a cooling liquid according to Claim 1, wherein
the communication portion is slits that are formed on the bonding surface of the bracket.

4. The device for detecting a temperature of a cooling liquid according to Claim 3, wherein
the slits are formed at intervals of 3 mm or less.

5. The device for detecting a temperature of a cooling liquid according to Claim 1, wherein
the communication portion is a through hole that is formed to pass through the bonding surface of the bracket and a surface that is opposite to the bonding surface.

6. The device for detecting a temperature of a cooling liquid according to Claim 1, wherein
the cooling section is mounted on electrical equipment for cooling a heating element of the electrical equipment.
